# EUROPÄISCHE PATENTSCHRIFT

(11) **EP 2 617 095 B1**
(45) Veröffentlichungstag und Bekanntmachung des Hinweises auf die Patenterteilung: **20.01.2016**
(21) Anmeldenummer: 11751573.4
(22) Anmeldetag: 12.08.2011
(51) Int. Cl.: H01M 10/42, H01M 10/48, G01R 31/36

(54) **BATTERIESYSTEM MIT ZELLSPANNUNGSERFASSUNGSEINHEITEN**
BATTERY SYSTEM WITH CELL VOLTAGE DETECTING UNITS
SYSTÈME ACCUMULATEUR COMPORTANT DES UNITÉS DE MESURE DE LA TENSION DES ÉLÉMENTS

(30) Priorität: 14.09.2010 DE 102010040721
(43) Veröffentlichungstag der Anmeldung: 24.07.2013
(73) Patentinhaber: Robert Bosch GmbH, 70442 Stuttgart (DE); Samsung SDI Co., Ltd., Yongin-si Gyeonggi-do 446-577 (KR)
(72) Erfinder: BUTZMANN, Stefan, 71717 Beilstein (DE)
(74) Vertreter: Bee, Joachim
(86) Internationale Anmeldenummer: PCT/EP2011/063947
(87) Internationale Veröffentlichungsnummer: WO 2012/034798

(56) Entgegenhaltungen:
- WO-A1-99/27628
- US-A1- 2006 259 280

## Beschreibung

Die vorliegende Erfindung betrifft ein Batteriesystem, ein Verfahren zum Überwachen eines Batteriesystems sowie ein Kraftfahrzeug mit dem erfindungsgemäßen Batteriesystem.

### Stand der Technik

Es zeichnet sich ab, dass in Zukunft sowohl für stationäre Anwendungen, beispielsweise bei Windkraftanlagen, als auch Fahrzeugen, beispielsweise in Hybrid- und Elektrofahrzeugen, vermehrt neue Batteriesysteme zum Einsatz kommen werden, an die sehr hohe Anforderungen bezüglich der Zuverlässigkeit gestellt werden.

Hintergrund für diese hohen Anforderungen ist, dass ein Ausfall des Batteriesystems zu einem Ausfall des Gesamtsystems führen kann. Beispielsweise hat bei einem Elektrofahrzeug ein Ausfall der Traktionsbatterie einen so genannten "Liegenbleiber" zur Folge. Außerdem kann der Ausfall einer Batterie zu einem sicherheitsrelevanten Problem führen. Bei Windkraftanlagen werden beispielsweise Batterien eingesetzt, um bei starkem Wind die Anlage durch eine Rotorblattverstellung vor unzulässigen Betriebszuständen zu schützen.

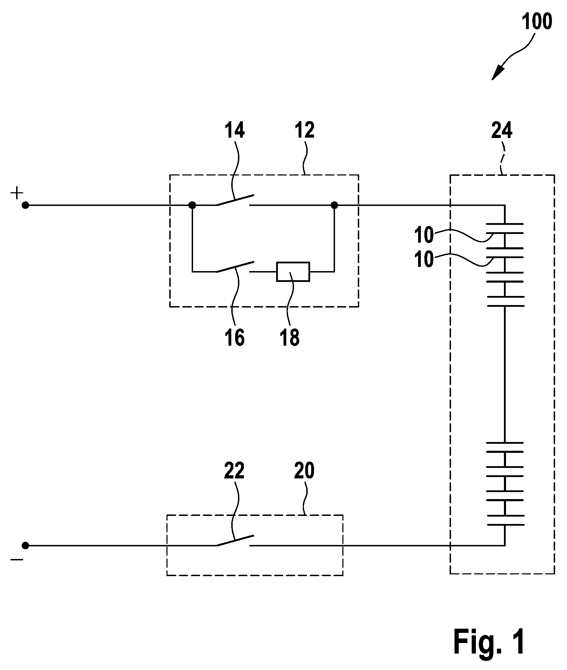

Das Prinzipschaltbild eines .Batteriesystems gemäß Stand der Technik ist in Figur 1 dargestellt. Ein insgesamt mit 100 bezeichnetes Batteriesystem umfasst eine Vielzahl von Batteriezellen 10, die in einem Modul 24 zusammengefasst sind. Ferner ist eine Lade- und Trenneinrichtung 12, welche einen Trennschalter 14, einen Ladeschalter 16 und einen Ladewiderstand 18 umfasst, vorgesehen. Zusätzlich kann das Batteriesystem 100 eine Trenneinrichtung 20 mit einem Trennschalter 22 umfassen.

Für den sicheren Betrieb des Batteriesystems 100 ist es zwingend notwendig, dass jede Batteriezelle 10 innerhalb eines erlaubten Betriebsbereichs (Spannungsbereich, Temperaturbereich, Stromgrenzen) betrieben wird. Liegt eine Batteriezelle 10 außerhalb dieser Grenzen, muss sie aus dem Zellverbund herausgenommen werden. Bei einer Serienschaltung der Batteriezellen 10 (wie in Figur 1 dargestellt) führt daher ein Ausfall einer einzelnen Batteriezelle 10 zum Ausfall des gesamten Batteriesystems 100.

Insbesondere in Hybrid- und Elektrofahrzeugen werden Batterien in Lithium-Ionen- oder Nickel-Metall-Hybrid-Technologie eingesetzt, die eine große Anzahl in Serie geschalteter elektrochemischer Batteriezellen aufweisen. Eine Batteriemanagementeinheit wird zur Überwachung der Batterie eingesetzt und soll neben einer Sicherheitsüberwachung eine möglichst hohe Lebensdauer gewährleisten. So wird beispielsweise eine Zellspannungserfassungseinheit eingesetzt.

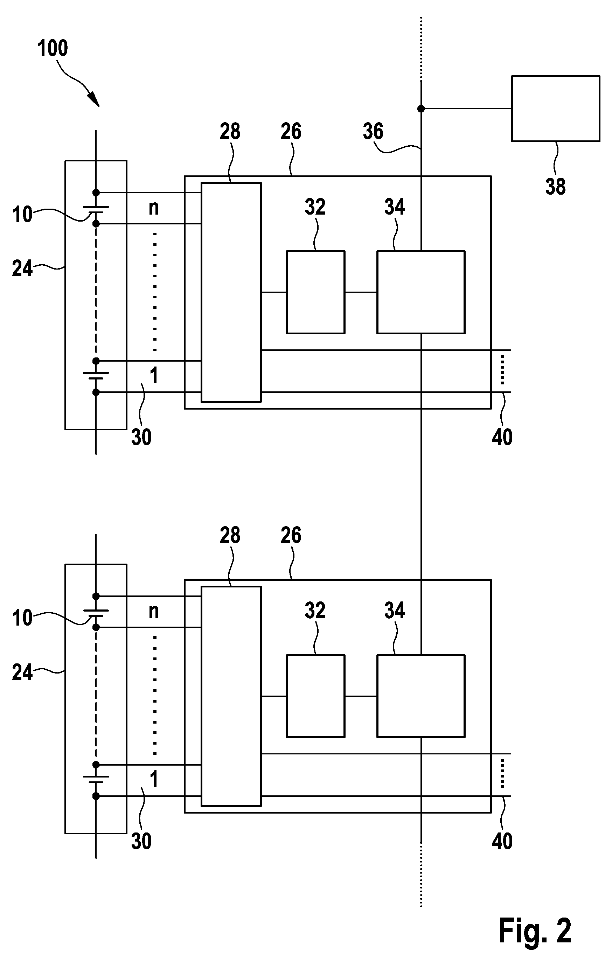

Figur 2 zeigt den bekannten Einsatz einer derzeitigen Zellspannungserfassungseinheit.

In Figur 2 ist eine aus dem Stand der Technik bekannte Architektur einer typischen Zellspannungserfassung gezeigt. Hierbei ist jedem Modul 24 mit seinen Batteriezellen 10 eine Zellspannungserfassungseinheit 26 zugeordnet. Die Zellspannungserfassungseinheit 26 umfasst einen Multiplexer 28, der über eine Anzahl der Batteriezellen 10 entsprechenden Anzahl von Kanälen 30 die Spannung jeder der einzelnen Batteriezellen 10 erfasst. Der Multiplexer 28 ist über einen Analog-Digital-Wandler 32 mit einem Gateway 34 verbunden, der an einem Kommunikationsbus 36 gekoppelt ist. An den Kommunikationsbus 36 ist ein zentraler Mikrocontroller 38 angeschlossen. Über diesen zentralen Mikrocontroller 38 können somit die Spannungen der einzelnen Batteriezellen 10 erfasst und ausgewertet werden. Der Mikrocontroller 38 kann Bestandteil einer Batteriemanagementeinheit sein.

Wie Figur 2 verdeutlicht, können hier mehrere Module 24 mit Batteriezellen 10 in Serie angeordnet sein, die jeweils über eine eigene Zellspannungserfassungseinheit 26 verfügen.

Die Multiplexer 28 besitzen hier angedeutete Hilfseingänge 40, die bekanntermaßen für eine Temperaturmessung dienen können, indem eine Erfassung von Widerstandswerten von NTC-Widerständen erfolgen kann. Die WO 99/27628 A1 offenbart zudem ein Batteriesystem enthaltend mehrere Batteriezellen, diesen zugeordneter Zellspannungserfassungsschaltung mit einem Multiplexer und einem Analog/Digital Wandler und einem Kommunikationsbus zu einem Mikrokontroller. Der Multiplexer ist über den Kommunikationsbus mit dem Mikrokontroller verbunden, wobei zusätzlich zu den erfassten Zellspannungen eine konstante Referenzspannung in den Multiplexer eingespeist wird.

Bei den bekannten Zellspannungsüberwachungen ist nachteilig, dass eine Fehlfunktion der Zellspannungserfassungseinheit, insbesondere des Analog-Digital-Wandlers, nicht erkannt werden kann. Die vom Analog-Digital-Wandler übertragenen Daten werden von der Auswerteeinheit als die tatsächlichen Spannungswerte als gegeben betrachtet. Sind diese jedoch fehlerhaft, kann es zu einem Fehlverhalten des gesamten Batteriesystems kommen.

### Offenbarung der Erfindung

Erfindungsgemäß wird ein Batteriesystem mit wenigstens einem Modul, das eine Vielzahl von Batteriezellen umfasst, zur Verfügung gestellt, wobei jeder Batteriezelle eine Zellspannungserfassungsschaltung zugeordnet ist, die Zellspannungserfassungsschaltungen eines Moduls mit einem Multiplexer verbunden sind, ein Ausgang des Multiplexers über einen Analog-Digital-Wandler mit einem Kommunikationsbus verbunden ist, der mit einer Auswerteeinheit verbunden ist, wobei der Multiplexer zusätzlich mit wenigstens einer der Auswerteinheit bekannten Hilfsspannungsquelle verbunden Erfindungsgemäss ist die Hilfsspannungsquelle eine pulsierende Spannungsquelle. Hierdurch wird vorteilhaft möglich, eventuelle Fehlfunktionen des Analog-Digital-Wandlers oder einer zum Analog-Digital-Wandler zugehörenden Referenz zu erkennen. Durch Einlesen der bekanten Hilfsspannungsquelle in den Multiplexer werden diese über den Analog-Digital-Wandler und den Kommunikationsbus der Auswerteeinheit mit übermittelt. Da die Auswerteeinheit die Hilfsspannungsquelle kennt, kann der der Hilfsspannungsquelle zugeordnete bekannte Spannungssignalverlauf erwartet werden. Wird dieser bekannte Spannungssignalverlauf ausgelesen, kann von einer ordnungsgemäßen Funktion des Analog-Digital-Wandlers ausgegangen werden. Wird jedoch dieser bekannte Spannungssignalverlauf nicht erkannt, ist auf eine Fehlfunktion des Analog-Digital-Wandlers oder eine fehlerhafte Spannungsreferenz des Analog-Digital-Wandlers zu schließen. In bevorzugter Ausgestaltung der Erfindung ist vorgesehen, dass als bekannte Hilfsspannungsquelle ein niederfrequenter Oszillator eingesetzt wird. Hierdurch wird besonders vorteilhaft möglich, die durch den Oszillator bestimmte niederfrequente Spannungsänderung aus dem Multiplexsignal zu erkennen. Insbesondere, wenn in bevorzugter Ausgestaltung ein Rechteckoszillator eingesetzt wird, bei dem zumindest einer der beiden möglichen Pegel, High bzw. Low, eine vorher bekannte genaue Spannungslage aufweist, lässt sich in besonders einfacher Weise das über den Multiplexer geführte Hilfsspannungssignal durch die zentrale Auswerteeinheit detektieren. Wird dieses pulsierende Spannungssignal nicht detektiert, ist auf eine Fehlfunktion des Analog-Digital-Wandlers zu schließen.

Erfindungsgemäß wird ferner ein Verfahren zur Überwachung eines Batteriesystems mit den Merkmalen des Anspruchs 4 bereitgestellt. Hierdurch lässt sich in einfacher Weise die ordnungsgemäße Funktion der Zellspannungserfassungseinheit prüfen und somit die bereitgestellten Ausgangssignale der Zellspannungserfassungseinheit verifizieren.

Erfindungsgemäss ist vorgesehen, dass zusätzlich zu den Zellspannungen der Batteriezellen wenigstens eine definierte bekannte pulsierende Hilfsspannung über die Zellspannungserfassungseinheit geführt und anschließend ausgewertet wird. Hierdurch wird sehr vorteilhaft erreicht, dass in einfacher Weise das Ausgangssignal auf das erwartete Hilfsspannungssignal hin überwacht wird. Wird dieses erwartete Hilfsspannungssignal erkannt, kann auf eine ordnungsgemäße Funktion der Zellspannungserfassungseinheit geschlossen werden. Wird das erwartete Hilfsspannungssignal jedoch nicht erkannt, liegt gegebenenfalls ein Fehler innerhalb der Zellspannungserfassungseinheit vor, so dass über ein entsprechendes Fehlermanagementsystem das Batteriesystem abgeschaltet, umgeschaltet oder auf andere geeignete Art und Weise beim weiteren Batteriemanagement berücksichtigt werden kann.

Ein weiterer Aspekt der Erfindung betrifft ein Kraftfahrzeug, welches das erfindungsgemäße Batteriesystem umfasst.

Insgesamt kann durch das erfindungsgemäße Batteriesystem bzw. das erfindungsgemäße Verfahren erreicht werden, dass die Zuverlässigkeit des Batteriesystems überprüft werden kann und eventuelle Fehlfunktionen rechtzeitig erkannt werden, um Folgeschäden durch unzuverlässig arbeitende Batteriesysteme zu vermeiden.

### Zeichnungen

Ausführungsbeispiele der Erfindung werden anhand der Zeichnungen und der nachfolgenden Beschreibung näher erläutert. Es zeigen:
Figur 1 ein Batteriesystem nach dem Stand der Technik,
Figur 2 eine Architektur einer Zellspannungserfassungseinheit nach dem Stand der Technik,
Figur 3 ein Batteriesystem in einem ersten Referenzbeispiel und
Figur 4 ein erfindungsgemäßes Batteriesystem in einem erfindungsgemässen Ausführungsbeispiel.

### Ausführungsformen der Erfindung

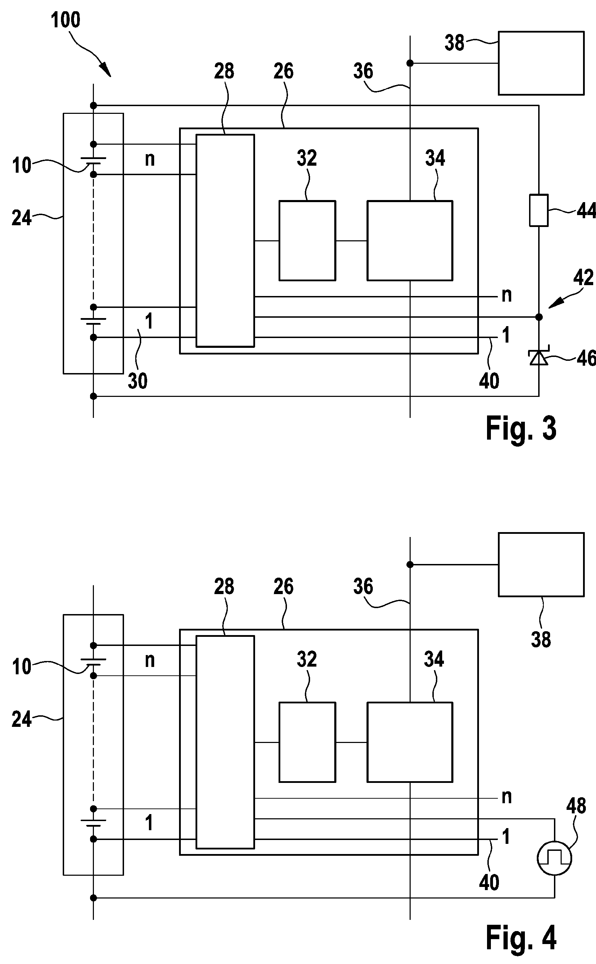

Figur 3 zeigt ein Batteriesystem 100 gemäß einem Referenzbeispiel. Eine Vielzahl von Batteriezellen 10 sind in Reihe geschaltet und in einem Modul 24 zusammengefasst. In einem Multiplexer 28 werden die Zellspannungen der einzelnen Batteriezellen 10 zusammengeführt und über einen Analog-Digital-Wandler 32 sowie ein Gateway 34 in einen Kommunikationsbus 36 eingespeist. Über den Mikrocontroller 38 erfolgt die Spannungsauswertung in an sich bekannter Art und Weise.

Zusätzlich ist einer der Hilfsanschlüsse 40 des Multiplexers 28 mit einer konstanten Hilfsspannung beaufschlagt. Diese konstante Hilfsspannung wird über eine Schaltungsanordnung 42 bereitgestellt, die einen Widerstand 44 sowie eine Zenerdiode 46 umfasst. Hierdurch wird über das Modul 24 eine konstante Spannung von beispielsweise 2,5 V abgegriffen und an den Hilfsanschluss 40 des Multiplexers 28 angelegt. Diese Hilfsspannung wird über die Zellspannungserfassungseinheit 26, das heißt über den Multiplexer 28, den Analog-Digital-Wandler 32 und den Gateway 34 ebenfalls dem Kommunikationsbus 36 und somit dem Mikrocontroller 38 zur Verfügung gestellt. Im Mikrocontroller 38 wird das dort ankommende Signal auf das Vorhandensein der definierten bekannten Hilfsspannung, hier beispielsweise von 2,5 V, überwacht. Wird diese Hilfsspannung ebenfalls erkannt, kann auf eine ordnungsgemäße Funktion der Zellspannungserfassungseinheit 26, insbesondere des Analog-Digital-Wandlers 32, geschlossen werden.

Figur 4 zeigt ein Batteriesystem 100 in einer Ausführungsform der Erfindung. Gleiche Teile wie in den vorhergehenden Figuren sind mit gleichen Bezugszeichen versehen und nicht nochmals erläutert.

Gemäß Figur 4 ist einer der Hilfsanschlüsse 40 des Multiplexers 28 mit einem Rechteckoszillator 48 verbunden. Der Rechteckoszillator 48 greift eine Spannung ab und stellt eine Rechteckspannung mit alternierenden Pegel High und Pegel Low zur Verfügung. Wenigstens einer der Pegel des Rechteckoszillators 48 wird auf eine bekannte definierte Höhe eingestellt. Beispielsweise beträgt der Pegel High einen Wert von 2,5 V und der Pegel Low einen Wert von 0,5 V. Dieses Rechtecksignal wird über den Multiplexer 28 dem Analog-Digital-Wandler 32 zu dem Gateway 34 auf den Kommunikationsbus 36 eingespeist und steht somit dem Mikrocontroller 38 zur Verfügung. Der Mikrocontroller 38 kennt den erwarteten pulsierenden Spannungsverlauf des Oszillators 48, insbesondere einen der erwarteten Pegel High bzw. Pegel Low. Liegt dieser Pegel in der erwarteten durch den Oszillator 48 vorgegebenen Frequenz an, kann auf ein korrektes Übertragungsverhalten der Zellspannungserfassungseinheit 26 geschlossen werden. Liegt dieses erwartete pulsierende Signal nicht an oder liegt das pulsierende Signal an, aber nicht der erwartete Spannungspegel, kann auf eine Fehlfunktion der Zellspannungserfassungseinheit 26 geschlossen werden.

## Patentansprüche

1. Batteriesystem (100) mit wenigstens einem Modul (24), das eine Vielzahl von Batteriezellen (10) umfasst, wobei jeder Batteriezelle (10) eine Zellspannungserfassungsschaltung zugeordnet ist, die Zellspannungserfassungsschaltungen eines Moduls (24) mit einem Multiplexer (28) verbunden sind, ein Ausgang des Multiplexers (28) über einen Analog-Digital-Wandler (32) mit einem Kommunikationsbus verbunden ist, der mit einer Auswerteeinheit verbunden ist, **dadurch gekennzeichnet, dass** der Multiplexer (28) zusätzlich mit wenigstens einer pulsierenden Hilfsspannungsquelle, deren erwarteter Spannungssignalverlauf der Auswerteinheit bekannt ist, verbunden ist und dazu ausgebildet ist, das anliegende Spannungssignal der pulsierenden Hilfsspannungsquelle zu erfassen und der Auswerteeinheit zuzuführen.

2. Batteriesystem nach Anspruch 1, **dadurch gekennzeichnet, dass** die pulsierende Hilfsspannungsquelle ein niederfrequenter Oszillator ist.

3. Batteriesystem nach Anspruch 2, **dadurch gekennzeichnet, dass** der niederfrequente Oszillator ein Rechteckoszillator ist.

4. Verfahren zum Überwachen eines Batteriesystems mit mindestens einem Modul mit einer Vielzahl von Batteriezellen, wobei eine Spannung jeder der Batteriezellen erfasst und über eine Zellspannungserfassungseinheit einer Auswerteeinheit zugeführt wird, **dadurch gekennzeichnet, dass** zusätzlich zu den Zellspannungen der Batteriezellen (10) wenigstens ein anliegendes Spannungssignal einer pulsierenden Hilfsspannungsquelle, deren erwarteter Spannungssignalverlauf der Auswerteinheit bekannt ist, mittels der Zellspannungserfassungseinheit erfasst und der Auswerteeinheit zugeführt wird und von der Auswerteeinheit anschließend ausgewertet wird.

5. Kraftfahrzeug mit einem Batteriesystem (100) nach einem der vorhergehenden Ansprüche, wobei das Batteriesystem (100) mit einem Antriebssystem des Kraftfahrzeugs verbunden ist.

## Claims

1. Battery system (100) having at least one module (24) which comprises a multiplicity of battery cells (10), wherein each battery cell (10) has an associated cell voltage sensing circuit, the cell module sensing circuits of a module (24) are connected to a multiplexer (28), and an output of the multiplexer (28) is connected via an analog-to-digital converter (32) to a communication bus which is connected to an evaluation unit, **characterized in that** the multiplexer (28) is additionally connected to at least one pulsating auxiliary voltage source, whose expected voltage signal profile is known to the evaluation unit, and is designed to detect the applied voltage signal from the pulsating auxiliary voltage source and to supply it to the evaluation unit.

2. Battery system according to Claim 1, **characterized in that** the pulsating auxiliary voltage source is a low frequency oscillator.

3. Battery system according to Claim 2, **characterized in that** the low frequency oscillator is a square wave oscillator.

4. Method for monitoring a battery system having at least one module having a multiplicity of battery cells, wherein a voltage for each of the battery cells is sensed and is supplied via a cell voltage sensing unit to an evaluation unit, **characterized in that** in addition to the cell voltages of the battery cells (10) at least one applied voltage signal from a pulsating auxiliary voltage source, whose expected voltage signal profile is known to the evaluation unit, is detected by means of the cell voltage detection unit and supplied to the evaluation unit and is then evaluated by the evaluation unit.

5. Motor vehicle having a battery system (100) according to one of the preceding claims, wherein the battery system (100) is connected to a drive system in the motor vehicle.

## Revendications

1. Système accumulateur (100) comprenant au moins un module (24), qui comprend une pluralité de cellules d'accumulateur (10), un circuit de détection de tension de cellule étant associé à chaque cellule d'accumulateur (10), les circuits de détection de tension de cellule d'un module (24) étant connectés à un multiplexeur (28), une sortie du multiplexeur (28) étant connectée par le biais d'un convertisseur analogique-numérique (32) à un bus de communication qui est connecté à une unité d'analyse, **caractérisé en ce que** le multiplexeur (28) est en outre connecté à au moins une source de tension auxiliaire pulsée dont la courbe de signal de tension attendue est connue de l'unité d'analyse, et est configuré pour détecter le signal de tension appliqué de la source de tension auxiliaire pulsée pour l'acheminer à l'unité d'analyse.

2. Système accumulateur selon la revendication 1, **caractérisé en ce que** la source de tension auxiliaire pulsée est un oscillateur basse fréquence.

3. Système accumulateur selon la revendication 2, **caractérisé en ce que** l'oscillateur basse fréquence est un oscillateur rectangulaire.

4. Procédé de contrôle d'un système accumulateur comprenant au moins un module ayant une pluralité de cellules d'accumulateur, une tension de chaque cellule d'accumulateur étant détectée et étant acheminée à une unité d'analyse par le biais d'une unité de détection de tension de cellule, **caractérisé en ce qu'**en plus des tensions de cellule des cellules d'accumulateur (10), au moins un signal de tension appliqué d'une source de tension auxiliaire pulsée, dont la courbe de signal de tension attendue est connue de l'unité d'analyse, est détecté au moyen de l'unité de détection de tension de cellule et est acheminé à l'unité d'analyse, puis est analysé par l'unité d'analyse.

5. Véhicule automobile comprenant un système accumulateur (100) selon l'une quelconque des revendications précédentes, dans lequel le système accumulateur (100) est connecté à un système d'entraînement du véhicule automobile.
